# FASCICULE DE BREVET EUROPEEN

(11) **EP 1 803 051 B1**
(45) Date de publication et mention de la délivrance du brevet: **03.06.2009**
(21) Numéro de dépôt: 05809140.6
(22) Date de dépôt: 14.10.2005
(51) Int. Cl.: G06F 1/20

(54) **DISPOSITIF A FLUIDE DE REFROIDISSEMENT POUR ORDINATEUR**
FLÜSSIGKEITSKÜHLVORRICHTUNG FÜR EINEN COMPUTER
LIQUID COOLING DEVICE FOR A COMPUTER

(30) Priorité: 15.10.2004 FR 0410888
(43) Date de publication de la demande: 04.07.2007
(73) Titulaire: J.C.C. Chereau Aéronautique, 37110 Morand (FR)
(72) Inventeur: CHEREAU, Jean Claude, F-37110 Dame Marie les Bois (FR)
(74) Mandataire: Debay, Yves
(86) Numéro de dépôt international: PCT/FR2005/002551
(87) Numéro de publication internationale: WO 2006/042945

(56) Documents cités:
- WO-A-99/11108
- GB-A- 2 349 985
- US-A1- 2002 196 604
- US-A1- 2004 008 483
- US-A1- 2004 027 801
- US-B1- 6 234 240

## Description

La présente invention se rapporte au domaine des systèmes de refroidissement pour système informatique. L'invention concerne plus particulièrement un dispositif à fluide de refroidissement permettant de refroidir un ordinateur autrement que par des systèmes bruyants de ventilation forcée.

Les microprocesseurs sont de plus en plus puissants et les divers composants d'ordinateur nécessitent désormais des refroidissements importants. Actuellement pour refroidir ces éléments, il est le plus souvent utilisé des blocs d'aluminium associés à des ventilateurs puissants très bruyants et gourmands en énergie, qui engendrent à l'intérieur d'un boîtier d'ordinateur une température importante.

Dans les pays chauds, la température étant supérieure à 30°C, le système par ventilateur à air forcé ne convient pas pour des conditions de fonctionnement normales. Il nécessite souvent un local avec climatiseur.

Il est connu, notamment par les documents us 2002/196604, GB 2 349 985, WO 99/11108 ou encore us 6 234 240 des systèmes de refroidissement par circulation d'un liquide prévus dans le boîtier de l'ordinateur pour refroidir certains composants électroniques. Toutefois ces systèmes sont souvent d'une efficacité limitée, ne permettant pas toujours de se passer de ventilateurs de puissance pour le refroidissement de microprocesseurs puissants et posent en outre des problèmes d'encombrement (volume supplémentaire pour intégrer certains éléments d'évacuation de chaleur du circuit).

La présente invention a donc pour objet de pallier un ou plusieurs des inconvénients de l'art antérieur en définissant un dispositif refroidisseur vraiment efficace et ne nécessitant pas une ventilation bruyante.

A cet effet, l'invention concerne un dispositif à fluide de refroidissement pour ordinateur, comportant des moyens d'évacuation de chaleur associés à au moins une paroi pour dissiper de la chaleur par effet radiateur, chacun des moyens d'évacuation de chaleur incluant deux parois espacées en matériau thermiquement conducteur entre lesquelles est formé au moins un canal de circulation d'un fluide, ledit canal étant relié à au moins un élément de refroidissement accolé à un composant électronique de l'ordinateur par un circuit fermé incluant un organe de pompage; caractérisé en ce que: chacune des deux parois délimitent le canal; et les parois d'au moins un des moyens d'évacuation de chaleur forment une paroi externe et interne d'un boîtier du type renfermant une unité de traitement d'un ordinateur, lesdits moyens d'évacuation de chaleur étant sensiblement répartis sur l'ensemble du boîtier pour faire jouer au boîtier le rôle d'un échangeur thermique avec l'extérieur.

Ainsi l'invention permet un refroidissement uniquement par le boîtier de l'ordinateur, sans augmenter l'encombrement du boîtier. Aucun radiateur spécifique n'est nécessaire et le dispositif permet de se passer des ventilateurs de puissance, ce qui rend l'ordinateur particulièrement silencieux.

Selon une autre particularité, lesdites deux parois sont planes et formées par une couche de tôle en aluminium ou cuivre, l'espacement entre ces parois étant compris entre 2 et 5 mm.

Ainsi l'invention permet un refroidissement efficace des composants chauffants tout en minimisant le volume occupé par le circuit de refroidissement.

Selon une autre particularité, des moyens d'évacuation de chaleur sont accolés contre des parois d'un boîtier du type ayant des parois de dessous, de dessus, et des parois latérales pour délimiter un volume intérieur servant à renfermer une unité de traitement d'un ordinateur, un premier moyen d'évacuation de chaleur étant associé à une paroi de dessous du boîtier, un second moyen d'évacuation de chaleur étant associé à une paroi de dessus du boîtier, au moins un troisième moyen d'évacuation de chaleur étant associé à au moins une paroi latérale du boîtier.

Selon une autre particularité, chacun des moyens d'évacuation de chaleur est à parois doubles constitutives du boîtier.

Selon une autre particularité, au moins un des moyens d'évacuation de chaleur est accolé à une paroi en matériau thermiquement conducteur d'un meuble.

Selon une autre particularité, le circuit fermé de circulation du fluide de refroidissement comprend au moins une sortie obturée par un élément de fermeture, un dispositif d'expansion étant prévu soit à au moins une sortie, soit en dérivation, pour permettre la dilatation du fluide de refroidissement.

Selon une autre particularité, le dispositif d'expansion comprend une membrane souple et étanche en matière plastique et est disposé à l'intérieur du boîtier.

Selon une autre particularité, le circuit fermé comprend :
- une pluralité de tuyaux de raccordement pour alimenter en fluide chaque canal de circulation des moyens d'évacuation de chaleur ;
- un appareil de contrôle de débit du fluide ;
- des moyens de distribution du fluide.

Selon une autre particularité, l'élément de refroidissement est doté d'une zone de circulation d'un fluide de refroidissement entre deux parois en vis-à-vis dont au moins une est accolée sur un microprocesseur et/ou d'autres composants électroniques de puissance de l'ordinateur.

Selon une autre particularité, chacun des éléments de refroidissement est uniquement en contact avec un composant électronique dégageant de la chaleur, des moyens de fixation étant prévus sur chaque élément de refroidissement pour solidariser ce dernier contre le composant électronique à refroidir.

Selon une autre particularité, le circuit fermé inclut :
- un élément de refroidissement pour refroidir un organe d'alimentation de l'ordinateur ;
- un élément de refroidissement pour refroidir un composant électronique du type carte graphique ;
- un élément de refroidissement pour refroidir un moyen de mémorisation de masse de l'ordinateur ;
- un élément de refroidissement pour refroidir un composant contrôleur des échanges entre le microprocesseur et la mémoire de travail de l'ordinateur ;
- un élément de refroidissement pour refroidir le microprocesseur de l'ordinateur.

Selon une autre particularité, des capteurs de contrôle et de sécurité sont prévus dans au moins un moyen d'évacuation de chaleur accolé à une des parois du boîtier pour réaliser la mesure de la température et/ou de la pression du fluide de refroidissement.

Selon une autre particularité, des moyens de détection optique, magnétique et/ou radio sont en outre prévus pour estimer des propriétés qualitatives du fluide de refroidissement.

Selon une autre particularité, le circuit fermé est relié à un échangeur de chaleur intégré ou non au boîtier, le fluide de refroidissement étant un liquide choisi parmi l'eau, l'huile, le mono éthylène glycol et liquide de refroidissement similaire du type ayant une ou plusieurs fonctions alcool.

Selon une autre particularité, le circuit fermé comprend des moyens de connexion à au moins une portion de circuit extérieure au boîtier permettant de refroidir ledit fluide de refroidissement.

Selon une autre particularité, au moins un agitateur d'air à faible vitesse de rotation est prévu à l'intérieur du boîtier pour générer un micro balayage de l'air permettant de refroidir des petits composants de l'ordinateur.

Selon une autre particularité, le circuit fermé est équipé d'au moins un élément à résistance électrique pour transformer le refroidissement en réchauffement.

L'invention, avec ses caractéristiques et avantages, ressortira plus clairement à la lecture de la description faite en référence aux dessins annexés donnés à titre d'exemples non limitatifs dans lesquels :
- la figure 1 représente schématiquement les connexions entre les éléments constitutifs du dispositif dans un mode de réalisation de l'invention ;
- la figure 2 montre un schéma de circulation du fluide de refroidissement dans un boîtier d'ordinateur selon un mode de réalisation de l'invention ;
- la figure 3 représente une vue en perspective de l'intérieur d'un boîtier d'ordinateur équipé d'un dispositif à fluide de refroidissement selon l'invention ;
- la figure 4 montre un élément de refroidissement local par effet radiateur pouvant être connecté au circuit de refroidissement pour refroidir un composant électronique de puissance.

Le dispositif selon l'invention présente de manière avantageuse une architecture de faible encombrement pour refroidir les composants électroniques de puissance d'un ordinateur et de divers périphériques : disque dur, alimentations, etc. Pour cela, le dispositif intègre une circulation d'un liquide: huile, eau, ou autres produits liquides conducteurs thermiquement. Dans le cas présent, un glycol automobile tel que le mono éthylène glycol convient parfaitement pour le refroidissement. Des liquides de refroidissement similaires du type ayant une ou plusieurs fonctions alcool, peuvent naturellement être utilisés. Un volume de liquide de moins d'un litre peut suffire, par exemple 0,8 L.

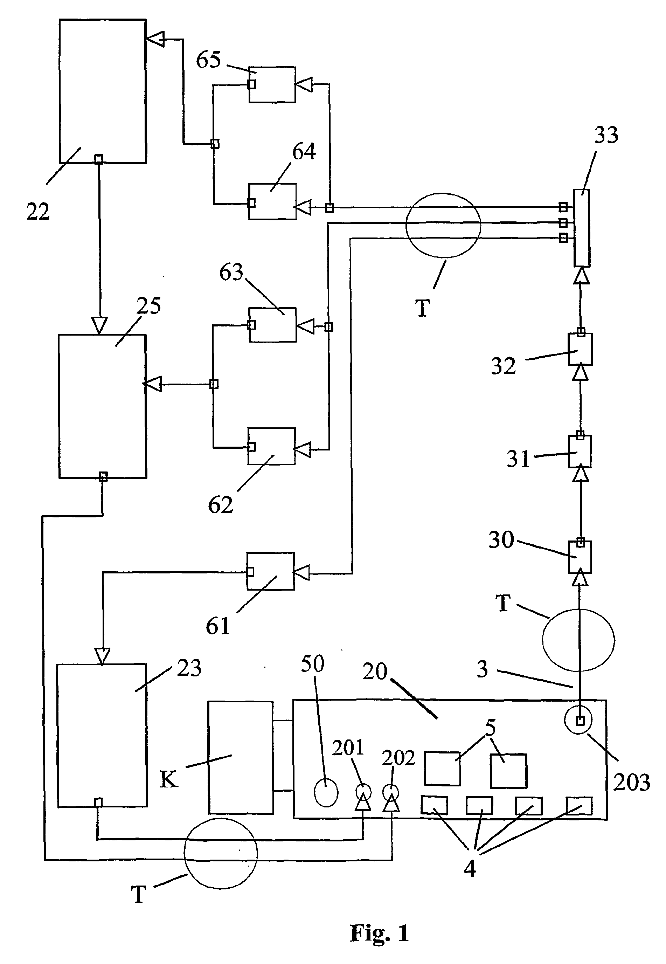

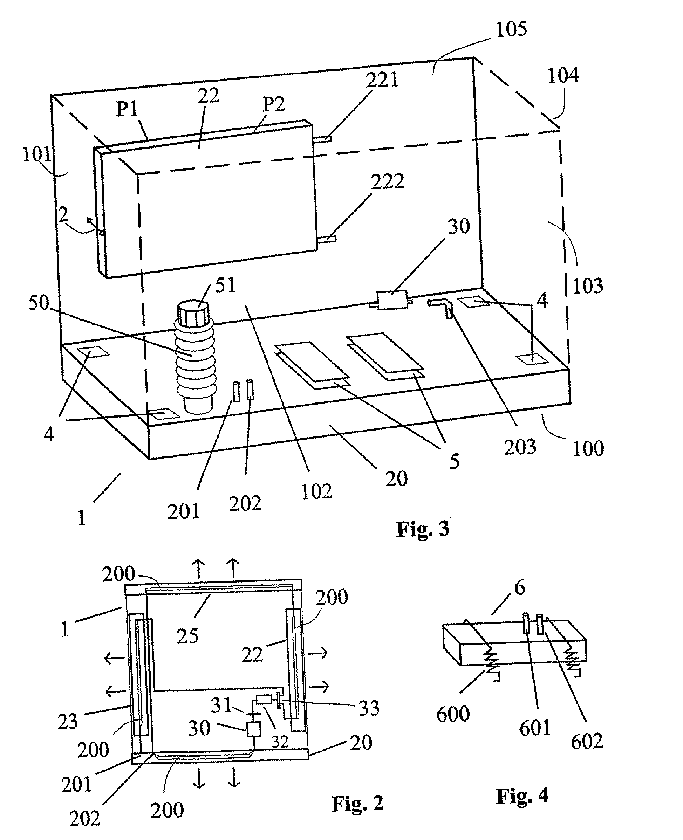

Le dispositif à fluide de refroidissement permet d'équiper un boîtier (1) d'unité centrale d'un ordinateur. Un tel boîtier (1) servant à renfermer l'unité de traitement d'un ordinateur comporte des parois de dessous (100), de dessus (105), et des parois latérales (102, 103). Dans le volume intérieur délimité par ces parois (100, 102, 103, 105), le dispositif comporte différents moyens de refroidissement et de dissipation de chaleur. Dans l'exemple des figures 1 et 2, un premier moyen d'évacuation de chaleur (20) est accolé contre une paroi de dessous (100), un second moyen d'évacuation de chaleur (25) est accolé contre une paroi de dessus (105) et des troisièmes moyens d'évacuation de chaleur (22, 23) sont adossés à au moins une paroi latérale (102, 103). Chacun des ces moyens d'évacuation de chaleur (20, 22, 23, 25) permet de dissiper la chaleur vers l'extérieur du boîtier (1) par effet radiateur, comme illustré par les flèches représentées sur la figure 2. Dans un mode de réalisation préféré de l'invention, chacun desdits premiers, seconds et troisièmes moyens d'évacuation de chaleur (20, 22, 23, 25) comprend deux parois (P1, P2, figure 3) en matériau thermiquement conducteur espacées, pour permettre la circulation d'un fluide de refroidissement dans au moins un canal (200) de circulation d'un fluide. Ledit canal (200) est relié à au moins un élément de refroidissement (6) accolé à un composant électronique de l'ordinateur par un circuit fermé (3). Le canal (200) formé dans l'espacement (2) ménagé entre lesdites deux parois (P1, P2) peut avoir un agencement de type serpentin, circulaire ou tout autre agencement pour permettre l'effet radiateur.

Le principal avantage de tels moyens d'évacuation de chaleur (20, 22, 23, 25) collés ou fixés contre les parois du boîtier (1) est d'utiliser le boîtier (1) de l'ordinateur comme radiateur. Celui-ci dissipe la chaleur dans l'air ambiant grâce au fluide de refroidissement qui circule à l'intérieur du dispositif. Ce fluide de refroidissement circule par exemple dans au moins un circuit fermé (3) doté d'un organe de pompage (30), comme illustré notamment à la figure 2. Dans un mode de réalisation de l'invention, la totalité du boîtier (1) ou au moins certaines surfaces du boîtier (1) servant à dissiper la chaleur sont par exemple constituées à base d'aluminium (fonte d'alumine) ou autre métal adapté (ou certains plastiques suffisamment conducteurs), assurant une transmission de chaleur par rayonnement et par convection. Autrement dit, le boîtier (1) joue le rôle d'un échangeur thermique avec l'extérieur. En réduisant au minimum l'épaisseur des parois (100, 102, 103, 105) du boîtier (1), les échanges thermiques avec l'extérieur sont ainsi améliorés puisque la résistance thermique du couvercle (23) est alors moindre. La surface d'échange thermique avec l'air intérieur à refroidir peut en outre être augmentée par utilisation d'un gaufrage.

Selon l'invention, au moins un des moyens d'évacuation de chaleur (20, 22, 23, 25) peut constituer au moins un élément de paroi du boîtier (1). Le boîtier (1) comporte alors des parois doubles (P1, P2) entre lesquelles est formé au moins un canal (200) de circulation du fluide. Dans un type de variante, une ou plusieurs parois en matériau thermiquement conducteur d'un meuble peuvent servir à dissiper la chaleur. Ainsi une table métallique sur laquelle est disposé l'ordinateur peut convenir à l'obtention de l'effet radiateur, au moins un des moyens d'évacuation de chaleur (20, 22, 23, 25) étant accolé à cette table.

Comme illustré à la figure 3, les deux parois (P1, P2), parallèles à la surface adjacente du boîtier (1), sont par exemple planes et formées par une couche de tôle en aluminium ou cuivre. L'espacement (2) entre ces parois (P1, P2) est compris entre 2 et 5 mm pour réduire l'encombrement dans le boîtier (1). Une épaisseur allant jusqu'à 10 mm est également envisageable. Sur chacun des moyens de refroidissement (20, 22, 23, 25) accolés contre les surfaces intérieures du boîtier (1), une entrée (221) et une sortie (222) sont prévues sous la forme de connecteurs aptes à recevoir des tuyaux (T) de raccordement au reste du circuit fermé (3). Comme illustré à la figure 3, le circuit fermé (3) de circulation du fluide de refroidissement comprend au moins une sortie obturée par un élément de fermeture (51). Un dispositif d'expansion (50) est en outre prévu à une telle sortie pour permettre la dilatation du fluide de refroidissement. En variante, le dispositif d'expansion (50) peut être disposé dans une dérivation du circuit (3). Ce dispositif d'expansion (50), disposé à l'intérieur du boîtier (1), comprend par exemple une membrane souple et étanche en matière plastique. Une forme en accordéon ou analogue pour ce dispositif (50) permet un mouvement de retrait/expansion autorisant la dilatation du fluide sans que la pression n'augmente dans le circuit (3).

Dans un mode de réalisation préféré de l'invention, les moyens de refroidissement (20) de la partie basse du boîtier (1) forment un compartiment inférieur sur lequel peut reposer l'ensemble de l'ordinateur, comme illustré à la figure 3. Ce compartiment peut être doté de pieds et d'une bande de mousse filtrante (non représentée) servant à filtrer un air entrant dans le boîtier (1).

En référence aux figures 1 et 3, des capteurs (4) de contrôle et de sécurité sont prévus dans des moyens d'évacuation de chaleur accolés à une des parois (100, 102, 103, 105) du boîtier (1) pour réaliser la mesure de la température et/ou de la pression du fluide de refroidissement. Des moyens de détection optique, magnétique et/ou radio peuvent être prévus pour estimer des propriétés qualitatives du fluide de refroidissement. L'opacité d'un liquide employé comme fluide de refroidissement peut ainsi être estimée par un capteur optique.

Comme représenté à la figure 2, le circuit fermé (3) peut être doté d'une pluralité de tuyaux (T) de raccordement pour alimenter en fluide de refroidissement chaque canal (200) de circulation des moyens d'évacuation de chaleur (20, 22, 23, 25). Les éléments de refroidissement (6) formant des radiateurs locaux sont également alimentés de la sorte. Ledit circuit (3) prévoit également un appareil (32) de contrôle de débit du fluide de refroidissement et des moyens de distribution (33) de ce fluide. Un filtre (31) pour liquide peut en outre équiper le circuit fermé (3). L'organe de pompage (30) utilisé est par exemple une micro-pompe de faible encombrement disposée à l'intérieur du boîtier (1). Un boîtier de dégazage liquide peut en outre être prévu.

Dans le mode de réalisation des figures 1 et 3, le moyen d'évacuation de chaleur (20) associé à la paroi de dessous (100) incorpore deux entrées (201, 202) pour le fluide de refroidissement et une sortie (203). L'organe de pompage (30) est par exemple connecté à cette sortie (203) par l'intermédiaire d'un tuyau (T) de type tubulure de caoutchouc résistante semi-souple ou analogue. Les tuyaux (T) utilisés pour le raccordement entre éléments de refroidissement sont également de ce type. Des tuyaux transparents peuvent être utilisés pour faciliter le contrôle optique/visuel de la circulation d'un liquide de refroidissement.

En référence aux figures 1 et 4, au moins un élément de refroidissement (6) du type doté d'une zone de circulation d'un fluide de refroidissement entre deux parois en vis-à-vis est disposé sur un microprocesseur et/ou d'autres composants électroniques de puissance de l'ordinateur. En pratique, chacun de ces éléments de refroidissement (6) peut être constitué par un petit boîtier creux en matériau de type aluminium, cuivre ou toute autre matière métallique dans lequel circule le liquide/fluide à l'aide d'une micro pompe ou autre organe de pompage. L'élément de refroidissement (6) est raccordé au circuit fermé (3) par des tuyaux (T) pour être alimenté en fluide de refroidissement. Chacun des éléments de refroidissement (6) forme un radiateur local (61, 62, 63, 64, 65, figure 1) uniquement en contact avec un composant électronique dégageant de la chaleur. Des moyens de fixation (600) peuvent être prévus sur chaque élément de refroidissement (6) pour solidariser ce dernier contre le composant électronique à refroidir. Ces moyens de fixation (600) peuvent inclure des ressorts dotés de crochets ou autres points de fixation ou en variante des lames d'acier inox souple se fixant autour des composants à refroidir. Tout autre organe de fixation (vis, etc.) peut naturellement être envisagé. En variante, ces éléments de refroidissement (6) sont simplement posés sur les parties électroniques à refroidir par collage. Le contact direct avec le composant permet d'obtenir une parfaite conductivité de la chaleur et optimise le refroidissement. Les moyens de refroidissement (20, 22, 23, 25) placés contre les surfaces intérieures du boîtier (1) et les éléments de refroidissement (6) ont par exemple chacun une forme globale parallélépipédique et disposent d'une connexion d'entrée respectivement de sortie pour le fluide de refroidissement. Pour les éléments (6) de refroidissement local d'un composant, une face est prévue pour le contact avec le composant, tandis que la face opposée comporte les connexions respectives (601, 602) d'entrée et de sortie du fluide de refroidissement.

Dans un mode de réalisation de l'invention, il est prévu pour au moins un des éléments (6) de refroidissement une structure à au moins deux étages. Un premier étage d'épaisseur réduite de l'ordre de quelques millimètres comprend un substrat isolateur ayant un fort coefficient thermique d'isolation pour former une interface d'isolation entre le composant et un deuxième étage traversé par le fluide de refroidissement. Ledit premier étage peut avoir une structure stratifiée. Cet élément de refroidissement à plusieurs étages peut être prévu notamment pour un composant alimenté en haute tension (par exemple 220 V). Le second étage est fixé au premier étage par des moyens de clipsage/vissage ou éléments de fixation analogues. Un tel élément de refroidissement (6) est adapté pour refroidir un organe d'alimentation de type classique.

En référence à la figure 1, les moyens de distribution (33) du liquide de refroidissement peuvent être reliés à certains desdits éléments de refroidissement (6) associés aux composants électroniques de puissance. Le circuit fermé (3) peut d'ailleurs comporter :
- un élément de refroidissement (61) pour refroidir un organe d'alimentation de l'ordinateur ;
- un élément de refroidissement (62) pour refroidir un composant électronique du type carte graphique ;
- un élément de refroidissement (63) pour refroidir un moyen de mémorisation de masse de l'ordinateur (disque dur ou carte mémoire) ;
- un élément de refroidissement (64) pour refroidir un composant contrôleur des échanges entre le microprocesseur et la mémoire de travail de l'ordinateur ;
- un élément de refroidissement (65) pour refroidir le microprocesseur de l'ordinateur.

Dans l'exemple de la figure 1, les connexions de sortie (602) de ces éléments de refroidissement (6) sont raccordées par des tuyaux (T) à l'entrée de moyens d'évacuation de chaleur (22, 23, 25) disposés contre des parois (102, 103, 105) du boîtier (1). Le moyen d'évacuation de chaleur (20) associé à la paroi de dessous (100) reçoit par exemple par une première entrée (201) le fluide de refroidissement ayant circulé le long de deux parois distinctes (102, 105) via des moyens d'évacuation de chaleur (22, 25) raccordés en série, et par une deuxième entrée (202) le fluide de refroidissement ayant circulé le long d'une autre paroi (103) du boîtier via un autre moyen d'évacuation de chaleur (23). Bien que la figure 1 illustre un circuit (3) dans lequel le fluide de refroidissement circule d'abord dans lesdits éléments (6) refroidissant localement des composants électroniques avant de circuler le long des parois du boîtier (1), il doit être compris que d'autres modes de réalisation du circuit fermé (3) peuvent être envisagés avec des branchements en parallèle et/ou en série différents. Lesdits éléments de refroidissement (6) peuvent être par exemple partiellement supprimés.

Dans le mode de réalisation de la figure 1, le circuit fermé (3) est relié à un échangeur de chaleur (K) intégré dans le boîtier (1). Il peut également être prévu un échangeur extérieur. L'utilisation d'un système échangeur offre une sécurité pour rendre impossible une surchauffe. Le circuit fermé (3) comprend alors par exemple des moyens de connexion à au moins une portion de circuit extérieure au boîtier (1) permettant de refroidir ledit fluide de refroidissement.

Dans des variantes de réalisation, il peut être prévu en outre une ou plusieurs cellules à effets Pelletier (non représentées), servant notamment à refroidir le processeur ou les organes d'alimentation. N'importe quel autre composant peut être également refroidi de cette façon. L'invention propose un refroidissement avec une faible consommation d'énergie et une absence de bruit. Dans le mode de réalisation des figures 1 et 3, l'ordinateur est ainsi refroidi de façon très simple sans ventilateur de puissance ; seulement deux agitateurs d'air (5) à faible vitesse de rotation sont utilisés par sécurité pour un micro-balayage de l'air à l'intérieur du boîtier (1) afin d'assurer le refroidissement de divers petits composants. L'encombrement du dispositif selon l'invention est minime, de sorte que ce type de refroidissement s'applique très bien à des PC portables.

Dans un mode de réalisation préféré du dispositif selon l'invention, un ou deux agitateurs d'air (5) faible vitesse de grand diamètre assurent le balayage d'air interne de façon pratiquement inaudible à environ 18db. Le flux d'air ainsi engendré refroidit les parois internes ainsi que divers petits composants de petite puissance. Ce flux peut également être canalisé pour assurer le refroidissement de la partie chaude des éventuels systèmes Pelletier. De la même manière, le flux d'air peut assurer le refroidissement des disques durs ou de leur électronique de surface et de l'alimentation, tout cela avec de l'air filtré en entrée par l'intermédiaire de la bande de mousse filtrante.

Il est possible également, pour des applications en milieu froid (avec une température de l'ordre de 0°C par exemple ou inférieure), d'équiper le circuit échangeur fermé (3) d'au moins un élément à résistance électrique asservie électroniquement pour assurer un maintien à une température suffisamment élevée de l'ordinateur, par exemple de l'ordre de 15-20°C. Le balayage d'air chaud produit par les agitateurs d'air (5) évite toute condensation. L'air étant filtré, le boîtier (1) peut être en légère surpression, ce qui permet d'éviter une accumulation de poussière dans le boîtier (1) et par exemple de protéger l'optique des poussières.

Les agitateurs d'air (5) fixés sur le compartiment inférieur formant un échangeur d'air récupèrent l'air pénétrant à travers la bande de mousse filtrante. Des trous d'acheminement de l'air partant de la bande de mousse filtrante traversent la partie supérieure du compartiment pour faire entrer l'air inspiré sous le boîtier (1). Dans un mode de réalisation de l'invention, un filtre en mousse de 5 x 5 x 80 (cm) est utilisé collé sous le boîtier (1). Ce filtre est intercalé entre le sol ou support et le compartiment inférieur. L'air ainsi aspiré sous le boîtier (1) se trouve refroidi de quelques degrés par le sol ou support sur lequel est posé celui-ci. Pour du carrelage ou béton ou support de ce genre, la température de l'air entrant se trouve abaissée de plusieurs degrés, ce qui est très appréciable dans les pays chauds. Les agitateurs d'air (5) sont par exemple activés par un système régulateur en fonction de l'élévation de la température. Le fonctionnement des systèmes à effet Pelletier est aussi géré par le système régulateur.

Un des avantages de l'invention est de fournir un refroidissement avec une forte dissipation de chaleur, ce qui permet l'utilisation de plusieurs ordinateurs dotés du dispositif à fluide de refroidissement dans un local sans problème d'élévation de température. En outre, le refroidissement peut être effectué de manière silencieuse, en supprimant les ventilateurs de puissance qui sont très bruyants et gourmands en énergie.

Un autre des avantages de l'invention est que l'ordinateur se retrouve refroidi de façon très simple avec une variation thermique lente, ce qui assure la longévité des parties refroidies et cela avec un coût de production très faible. Il s'agit simplement de rajouter au boîtier (1) d'un ordinateur des systèmes à deux couches de tôle, aluminium, ou métalliques divers ou certains plastiques suffisamment conducteurs avec un espacement (2) entre les deux parties de quelques millimètres d'épaisseur pour faire circuler un liquide à l'aide d'une micro pompe, ce qui permet d'assurer le rôle de radiateur.

En outre, l'utilisation d'une circulation de liquide avec une résistance thermique permet également de réchauffer l'ordinateur, ce qui autorise donc des applications en conditions extrêmes (très chaudes/très froides).

L'invention présente avantageusement un faible coût de fabrication et offre une bonne adaptabilité sur la plupart des ordinateurs du marché par soudage ou collage des éléments radiateurs, y compris pour les PC portables (l'encombrement est en effet très réduit puisque le boîtier de type Desktop a une épaisseur intérieure supplémentaire de 1 à 3 millimètres seulement). Par ailleurs, l'absence ou la réduction d'ouvertures d'aération permet de réduire ou d'éliminer la présence de poussières à l'intérieur du boîtier.

Il doit être évident pour les personnes versées dans l'art que la présente invention permet des modes de réalisation sous de nombreuses autres formes spécifiques sans l'éloigner du domaine d'application de l'invention comme revendiqué.

## Revendications

1. Dispositif à fluide de refroidissement pour ordinateur, comportant des moyens d'évacuation de chaleur (20, 22, 23, 25) associés à au moins une paroi (100, 102, 103, 105) pour dissiper de la chaleur par effet radiateur, chacun des moyens d'évacuation de chaleur incluant deux parois (P1, P2) espacées en matériau thermiquement conducteur entre lesquelles est formé au moins un canal (200) de circulation d'un fluide, ledit canal (200) étant relié à au moins un élément de refroidissement (6) accolé à un composant électronique de l'ordinateur par un circuit fermé (3) incluant un organe de pompage (30) ; **caractérisé en ce que** :
- chacune des deux parois (P1, P2) délimitent le canal (200) ; et
- les parois (P1, P2) d'au moins un des moyens d'évacuation de chaleur (20, 22, 23, 25) forment une paroi externe (P1) et interne (P2) d'un boîtier (1) du type renfermant une unité de traitement d'un ordinateur, lesdits moyens d'évacuation de chaleur (20, 22, 23, 25) étant sensiblement répartis sur l'ensemble du boîtier (1) pour faire jouer au boîtier (1) le rôle d'un échangeur thermique avec l'extérieur.

2. Dispositif selon la revendication 1, dans lequel lesdites deux parois (P1, P2) sont planes et formées par une couche de tôle en aluminium ou cuivre, l'espacement (2) entre ces parois (P1, P2) étant compris entre 2 et 5 mm.

3. Dispositif selon la revendication 1 ou 2, dans lequel des moyens d'évacuation de chaleur (20, 22, 23, 25) sont accolés contre des parois d'un boîtier (1) du type ayant des parois de dessous (100), de dessus (105), et des parois latérales (102, 103) pour délimiter un volume intérieur servant à renfermer une unité de traitement d'un ordinateur, un premier moyen d'évacuation de chaleur (20) étant associé à une paroi de dessous (100) du boîtier (1), un second moyen d'évacuation de chaleur (25) étant associé à une paroi de dessus (105) du boîtier (1), au moins un troisième moyen d'évacuation de chaleur (22, 23) étant associé à au moins une paroi latérale (102, 103) du boîtier (1).

4. Dispositif selon une des revendications 1 à 3, dans lequel chacun des moyens d'évacuation de chaleur (20, 22, 23, 25) est à parois doubles constitutives du boîtier (1).

5. Dispositif selon la revendication 1 ou 2, dans lequel au moins un des moyens d'évacuation de chaleur (20, 22, 23, 25) est accolé à une paroi en matériau thermiquement conducteur d'un meuble.

6. Dispositif selon une des revendications 1 à 5, dans lequel le circuit fermé (3) de circulation du fluide de refroidissement comprend au moins une sortie obturée par un élément de fermeture (51), un dispositif d'expansion (50) étant prévu soit à au moins une sortie, soit en dérivation, pour permettre la dilatation du fluide de refroidissement.

7. Dispositif selon la revendication 6, dans lequel le dispositif d'expansion (50) comprend une membrane souple et étanche en matière plastique et est disposé à l'intérieur du boîtier (1).

8. Dispositif selon une des revendications 1 à 4, dans lequel le circuit fermé (3) comprend :
- une pluralité de tuyaux (T) de raccordement pour alimenter en fluide chaque canal (200) de circulation des moyens d'évacuation de chaleur (20, 22, 23, 25) ;
- un appareil (32) de contrôle de débit du fluide ;
- des moyens de distribution (33) du fluide.

9. Dispositif selon une des revendications 1 à 8, dans lequel l'élément de refroidissement (6) est doté d'une zone de circulation d'un fluide de refroidissement entre deux parois en vis-à-vis dont au moins une est accolée sur un microprocesseur et/ou d'autres composants électroniques de puissance de l'ordinateur.

10. Dispositif selon une des revendications 1 à 9, dans lequel chacun des éléments de refroidissement (6) est uniquement en contact avec un composant électronique dégageant de la chaleur, des moyens de fixation (600) étant prévus sur chaque élément de refroidissement (6) pour solidariser ce dernier contre le composant électronique à refroidir.

11. Dispositif selon une des revendications 1 à 10, dans lequel le circuit fermé (3) inclut :
- un élément de refroidissement (61) pour refroidir un organe d'alimentation de l'ordinateur ;
- un élément de refroidissement (62) pour refroidir un composant électronique du type carte graphique ;
- un élément de refroidissement (63) pour refroidir un moyen de mémorisation de masse de l'ordinateur ;
- un élément de refroidissement (64) pour refroidir un composant contrôleur des échanges entre le microprocesseur et la mémoire de travail de l'ordinateur ;
- un élément de refroidissement (65) pour refroidir le microprocesseur de l'ordinateur.

12. Dispositif selon une des revendications 3 à 11, dans lequel des capteurs (4) de contrôle et de sécurité sont prévus dans au moins un moyen d'évacuation de chaleur accolé à une des parois (100, 102, 103, 105) du boîtier (1) pour réaliser la mesure de la température et/ou de la pression du fluide de refroidissement

13. Dispositif selon la revendication 12, dans lequel des moyens de détection optique, magnétique et/ou radio sont en outre prévus pour estimer des propriétés qualitatives du fluide de refroidissement.

14. Dispositif selon une des revendications 3 à 13, dans lequel le circuit fermé (3) est relié à un échangeur de chaleur (K) intégré ou non au boîtier (1), le fluide de refroidissement étant un liquide choisi parmi l'eau, l'huile, le mono éthylène glycol et liquide de refroidissement similaire du type ayant une ou plusieurs fonctions alcool.

15. Dispositif selon une des revendications 3 à 14, dans lequel le circuit fermé (3) comprend des moyens de connexion à au moins une portion de circuit extérieure au boîtier (1) permettant de refroidir ledit fluide de refroidissement.

16. Dispositif selon une des revendications 3 à 15, dans lequel au moins un agitateur d'air (5) à faible vitesse de rotation est prévu à l'intérieur du boîtier (1) pour générer un micro balayage de l'air permettant de refroidir des petits composants de l'ordinateur.

17. Dispositif selon une des revendications 1 à 16, **caractérisé en ce que** le circuit fermé (3) est équipé d'au moins un élément à résistance électrique pour transformer le refroidissement en réchauffement.

## Claims

1. A fluid cooling device for a computer, including heat removal means (20, 22, 23, 25) attached to at least one wall (100, 102, 103, 105) in order to dissipate the heat by a radiant effect, each of the heat removal means including two spaced walls (P1, P2) made from a heat conducting material between which is formed at least one channel (200) for circulation of a fluid, the said channel (200) being connected to at least one cooling element (6) attached to an electronic component of the computer by a closed circuit (3) including a pumping device (30), **characterised in that**:
- each of the two walls (P1, P2) delimits the channel (200); and
- the walls (P1, P2) of at least one of the heat removal means (20, 22, 23, 25) form an external wall (P1) and an internal wall (P2) of a housing (1) enclosing a computer processor, the said heat removal means (20, 22, 23, 25) being substantially distributed over the entire housing (1) in order to make the housing (1) act as a heat exchanger with the exterior.

2. Device according to claim 1, wherein the said two walls (P1, P2) are flat and formed by a layer of aluminium or copper sheet, the spacing (2) between these walls (P1, P2) being between 2 and 5 mm.

3. Device as claimed in Claim 1 or Claim 2, wherein heat-removal means (20, 22, 23, 25) are attached to walls of a housing (1) of the type having the lower wall (100), upper wall (105) and the lateral walls (102, 103) in order to delimit an interior volume which serves to enclose a computer processor, a first heat removal means (20) being associated with a lower wall (100) of the housing (1), a second heat removal means (25) being associated with an upper wall (105) of the housing (1), at least a third heat removal means (22, 23) being associated with at least a lateral wall (102, 103) of the housing (1).

4. Device as claimed in any one of Claims 1 to 3, wherein each of the heat removal means (20, 22, 23, 25) has two walls forming the housing (1).

5. Device as claimed in Claim 1 or 2, wherein at least one of the heat removal means (20, 22, 23, 25) is attached to a wall made from a heat conducting material of a piece of furniture.

6. Device as claimed in any one of Claims 1 to 5, wherein the closed circuit (3) for circulation of the cooling fluid comprises at least an outlet closed by a closure element (51), an expansion device (50) being provided either at at least one outlet or as a bypass in order to allow the expansion of the cooling fluid.

7. Device as claimed in Claim 6, wherein the expansion device (50) comprises a flexible leak-proof membrane made from plastics material and is installed inside the housing (1).

8. Device as claimed in any one of Claims 1 to 4, wherein the closed circuit (3) comprises:
- a plurality of connecting pipes (T) for supplying fluid to each circulation channel (200) of the heat removal means (20, 22, 23, 25);
- a fluid flow control device (32);
- fluid distribution means (33).

9. Device as claimed in any one of Claims 1 to 8, wherein the cooling element (6) is provided with a cooling fluid circulation zone between two walls facing one another of which at least one is attached to a microprocessor and/or other electronic power components of the computer.

10. Device as claimed in any one of Claims 1 to 9. wherein each of the cooling elements (6) is only in contact with an electronic component which releases heat, fixing means (600) being provided on each cooling element (6) in order to join this latter to the electronic component to be cooled.

11. Device as claimed in any one of Claims 1 to 10, wherein the closed circuit (3) includes:
- a cooling element (61) for cooling the supply device of the computer;
- a cooling element (62) for cooling an electronic component of the graphics card type;
- a cooling element (63) for cooling a mass storage means of the computer;
- a cooling element (64) for cooling a component for controlling exchanges between the microprocessor and the working memory of the computer;
- a cooling element (65) for cooling the microprocessor of the computer.

12. Device as claimed in any one of Claims 3 to 11, wherein the control and security sensors (4) are provided in at least one heat removal means attached to one of the walls (100, 102, 103, 105) of the housing (1) in order to carry out the measurement of the temperature and/or the pressure of the cooling fluid.

13. Device as claimed in Claim 12, wherein optical, magnetic and/or radio detection means are furthermore provided in order to estimate the qualitative properties of the cooling fluid.

14. Device as claimed in any one of Claims 3 to 13, wherein the closed circuit (3) is connected to a heat exchanger (K) which is or is not integrated into the housing (1), the cooling fluid being a fluid chosen from amongst water, oil, monoethyleneglycol and similar cooling fluids of the type having one or several alcohol functions.

15. Device as claimed in any one of Claims 3 to 14, wherein the closed circuit (3) comprises means for connection to at least a portion of circuit outside the housing (1) allowing the cooling of the said cooling fluid.

16. Device as claimed in any one of Claims 3 to 15, wherein at least one air agitator (5) with a low speed of rotation is provided in the interior of the housing (1) in order to generate a micro-scavenging of the air allowing the cooling of small components of the computer.

17. Device as claimed in any one of Claims 1 to 16, **characterised in that** the closed circuit (3) is equipped with at least one element having electric resistance in order to transform the cooling into heating.

## Patentansprüche

1. Kühlflüssigkeits-Vorrichtung für einen Rechner, Mittel zum Abführen von Wärme (20, 22, 23, 25) aufweisend, die mit mindestens einer Wand (100, 102, 103, 105) assoziiert sind, zum Ableiten der Wärme mittels eines Kühlereffekts, wobei jedes der Mittel zum Abführen von Wärme zwei im Abstand voneinander angeordnete Wände (P1, P2) aus einem thermisch leitenden Material aufweist, zwischen denen mindestens ein Kanal (200) zum Zirkulieren einer Flüssigkeit ausgebildet ist, wobei der Kanal (200) an mindestens ein Kühlelement (6) angeschlossen ist, das mittels eines geschlossenen Kreislaufs (3), der ein Pump-Mittel (30) aufweist, an eine elektronische Komponente des Rechners angebunden ist, **dadurch gekennzeichnet, dass**:
- jede der beiden Wände (P1, P2) den Kanal (200) begrenzt, und dass
- die Wände (P1, P2) von mindestens einem der Mittel zum Ableiten von Wärme (20, 22, 23, 25) eine äußere Wand (P1) und eine innere Wand (P2) eines Gehäuses (1) des Typs bilden, der eine Verarbeitungseinheit eines Rechners einschließt, wobei die Wärme-Ableitungs-Mittel (20, 22, 23, 25) im Wesentlichen über die Gesamtheit des Gehäuses (1) verteilt sind, so dass das Gehäuse (1) die Rolle eines Wärmetauschers mit dem Äußeren einnimmt.

2. Vorrichtung gemäß Anspruch 1, wobei die beiden Wände (P1, P2) eben und aus einer Blechschicht aus Aluminium oder Kupfer gebildet sind, wobei der Abstand (2) zwischen den Wänden (P1, P2) zwischen 2 mm und 5 mm liegt.

3. Vorrichtung gemäß Anspruch 1 oder 2, wobei Wärme-Ableitungs-Mittel (20, 22, 23, 25) an Wänden eines Gehäuses (1) des Typs mit einer unteren Wand (100), einer oberen Wand (105) und mit Seitenwänden (102, 103) zum Abgrenzen eines inneren Volumens angebracht sind, das zum Einschließen einer Verarbeitungseinheit eines Rechners dient, wobei ein erstes Mittel zum Ableiten von Wärme (20) mit einer unteren Wand (100) des Gehäuses (1) assoziiert ist, ein zweites Mittel zum Ableiten von Wärme (25) mit einer oberen Wand (105) des Gehäuses (1) assoziiert ist, und mindestens ein drittes Mittel zum Ableiten von Wärme (22, 23) mit mindestens einer Seitenwand (102, 103) des Gehäuses (1) assoziiert ist.

4. Vorrichtung gemäß einem der Ansprüche 1 bis 3, wobei jedes der Mittel zum Ableiten von Wärme (20, 22, 23, 25) doppelte Wände aufweist, die Bestandteil des Gehäuses (1) sind.

5. Vorrichtung gemäß Anspruch 1 oder 2, wobei mindestens eines der Mittel zum Ableiten von Wärme (20, 22, 23, 25) an einer Wand aus thermisch leitendem Material eines Möbelstücks angebracht ist.

6. Vorrichtung gemäß einem der Ansprüche 1 bis 5, wobei der geschlossene Kreislauf (3) für die Zirkulation der Kühlflüssigkeit mindestens einen Ausgang aufweist, der durch ein Schließungselement (51) verschlossen ist, wobei eine Ausdehnungsvorrichtung (50) zum Zulassen der Ausdehnung der Kühlflüssigkeit entweder an mindestens einem Ausgang oder an einer Ableitung vorgesehen ist.

7. Vorrichtung gemäß Anspruch 6, wobei die Ausdehnungsvorrichtung (50) eine nachgiebige und dichte Membran aus Kunststoffmaterial aufweist und im Inneren des Gehäuses (1) angeordnet ist.

8. Vorrichtung gemäß einem der Ansprüche 1 bis 4, wobei der geschlossene Kreislauf (3) aufweist:
- eine Mehrzahl von Anschlussrohrleitungen (T) zum Einspeisen von Flüssigkeit in jeden Zirkulationskanal (200) der Mittel zum Ableiten von Wärme (20, 22, 23, 25),
- eine Vorrichtung (32) zur Steuerung der Durchflussrate der Flüssigkeit,
- Mittel zum Verteilen (33) der Flüssigkeit.

9. Vorrichtung gemäß einem der Ansprüche 1 bis 8, wobei das Kühlelement (6) mit einem Zirkulationsbereich einer Kühlflüssigkeit zwischen zwei gegenüberliegenden Wänden versehen ist, wobei mindestens eine derselben an einen Mikroprozessor und/oder andere elektronische Leistungsbauteile des Rechners angebracht ist.

10. Vorrichtung gemäß einem der Ansprüche 1 bis 9, wobei jedes der Kühlelemente (6) ausschließlich mit einem elektronischen Bauteil in Kontakt ist, das Wärme freisetzt, wobei Fixierungsmittel (600) an jedem Kühlelement (6) zum Befestigen desselben an dem zu kühlenden elektronischen Bauteil vorgesehen sind.

11. Vorrichtung gemäß einem der Ansprüche 1 bis 10, wobei der geschlossene Kreislauf (3) aufweist:
- ein Kühlelement (61) zum Kühlen eines Stromversorgungsmittels des Rechners,
- ein Kühlelement (62) zum Kühlen eines elektronischen Bauteils des Grafikkarten-Typs,
- ein Kühlelement (63) zum Kühlen eines Massenspeichermittels des Rechners,
- ein Kühlelement (64) zum Kühlen einer Komponente zum Steuern des Austauschs zwischen dem Mikroprozessor und dem Arbeitsspeicher des Rechners,
- ein Kühlelement (65) zum Kühlen des Mikroprozessors des Rechners.

12. Vorrichtung gemäß einem der Ansprüche 3 bis 11, wobei Steuer- und Sicherheitssensoren (4) zum Durchführen der Messung der Temperatur und/oder des Drucks der Kühlflüssigkeit in mindestens einem Mittel zum Ableiten von Wärme vorgesehen sind, das an einer der Wände (100, 102, 103, 105) des Gehäuses (1) angebracht ist.

13. Vorrichtung gemäß Anspruch 12, wobei ferner Mittel zur optischen, magnetischen und/oder Funkdetektion zum Schätzen der qualitativen Eigenschaften der Kühlflüssigkeit vorgesehen sind.

14. Vorrichtung gemäß einem der Ansprüche 3 bis 13, wobei der geschlossene Kreislauf (3) an einen Wärmetauscher (K) angeschlossen ist, der in das Gehäuse (1) integriert ist oder nicht, wobei die Kühlflüssigkeit eine aus Wasser, Öl, Monoethylenglykol und einer ähnlichen Kühlflüssigkeit des Typs mit einer oder mehreren Alkoholfunktionen ausgewählte Flüssigkeit ist.

15. Vorrichtung gemäß einem der Ansprüche 3 bis 14, wobei der geschlossene Kreislauf (3) Mittel zum Anschließen an mindestens einen äußeren Kreislaufabschnitt am Gehäuse (1) aufweist, wodurch ein Kühlen der Kühlflüssigkeit ermöglicht wird.

16. Vorrichtung gemäß einem der Ansprüche 3 bis 15, wobei mindestens ein Luftrührwerk (5) mit geringer Rotationsgeschwindigkeit im Inneren des Gehäuses (1) zum Erzeugen einer Mikro-Luftspülung zum Ermöglichen des Kühlens der kleinen Komponenten des Rechners vorgesehen ist.

17. Vorrichtung gemäß einem der Ansprüche 1 bis 16, **dadurch gekennzeichnet, dass** der geschlossene Kreislauf (3) mit mindestens einem Element mit elektrischem Widerstand zum Umwandeln des Kühlens in ein Erwärmen versehen ist.
